# EUROPEAN PATENT APPLICATION

(11) **EP 4 373 224 A1**
(43) Date of publication of application: **22.05.2024**
(21) Application number: 23768769.4
(22) Date of filing: 08.09.2023
(51) Int. Cl.: H05K 3/28, H05K 1/02, H04M 1/02, H05K 1/14

(54) **FLEXIBLE CIRCUIT BOARD AND ELECTRONIC DEVICE COMPRISING SAME**

(30) Priority: 26.09.2022 KR 20220121517; 24.10.2022 KR 20220137522
(71) Applicant: Samsung Electronics Co., Ltd., Suwon-si, Gyeonggi-do 16677 (KR)
(72) Inventor: RA, Jaeyeon, Suwon-si, Gyeonggi-do 16677 (KR); LEE, Youngsun, Suwon-si, Gyeonggi-do 16677 (KR); PARK, Kookjin, Suwon-si, Gyeonggi-do 16677 (KR); SONG, Chagyu, Suwon-si, Gyeonggi-do 16677 (KR); JIN, Gyeongmin, Suwon-si, Gyeonggi-do 16677 (KR)
(74) Representative: Nederlandsch Octrooibureau
(86) International application number: PCT/KR2023/013509
(87) International publication number: WO 2024/071732

(57) **Abstract**

According to an embodiment of the disclosure, an electronic device may include a housing including a first housing and a second housing, a hinge structure configured to rotatably connect the first housing and the second housing, and a flexible circuit board at least partially disposed on the hinge structure, wherein the flexible circuit board includes a first area at least partially configured to be bendable, the first area including a first conductive layer, a (1-1)th coverlay layer stacked on the first conductive layer, and a (1-2)th coverlay layer stacked on the (1-1)th coverlay layer, and a second area configured to extend from the first area, the second area including a second conductive layer forming the same conductive layer as the first conductive layer, and a second coverlay layer forming the same coverlay layer as the (1-1)th coverlay layer. In addition, various embodiments may be possible.

## Description

### [Technical Field]

Various embodiments disclosed herein relate to an electronic device and, for example, to a flexible circuit board and an electronic device including the same.

### [Background Art]

In line with remarkable development of information/communication technologies, semiconductor technologies, and the like, there has been widespread use of various kinds of electronic devices. Particularly, recent electronic devices have been developed to be carried and used for communication.

Electronic devices may refer to devices configured to perform specific functions according to installed programs, such as home appliances, electronic organizers, portable multimedia players, mobile communication terminals, tablet PCs, video/audio devices, desktop/laptop computers, and vehicle navigation systems. For example, electronic devices may output stored information as sounds or images. In line with the high degree of integration of electronic devices and the widespread use of super-fast large-capacity wireless communication, it has recently become possible to equip a single electronic device (for example, mobile communication terminal) with various functions. For example, not only a communication function, but also an entertainment function (for example, gaming), a multimedia function (for example, music/video playback), communication and security functions for mobile banking and the like, a scheduling function, and an electronic wallet function may be integrated into a single electronic device. Such electronic devices have become compact such that users can conveniently carry the same.

### [Detailed Description of the Invention]

### [Technical Solution]

According to an embodiment of the disclosure, an electronic device may include a housing, a hinge structure, or a flexible circuit board. The housing may include a first housing and a second housing. The hinge structure may be configured to rotatably connect the first housing and the second housing. The flexible circuit board may be at least partially disposed in the hinge structure. The flexible circuit board may include a first area or a second area. The first area may be at least partially configured to be bendable. The first area may include a first conductive layer, a (1-1)th coverlay layer, or a (1-2)th coverlay layer. The (1-1)th coverlay layer may be stacked on the first conductive layer. The (1-2)th coverlay layer may be stacked on the (1-1)th coverlay layer. The second area may be configured to extend from the first area. The second area may include a second conductive layer or a second coverlay layer. The second conductive layer may be configured to form the same conductive layer as the first conductive layer. The second coverlay layer may configured to form the same coverlay layer as the (1-1)th coverlay layer.

According to an embodiment of the disclosure, a flexible circuit board may include a first area or a second area. The first area may be at least partially configured to be bendable. The first area may include a first conductive layer, a (1-1)th coverlay layer, or a (1-2)th coverlay layer. The (1-1)th coverlay layer may be stacked on the first conductive layer. The (1-2)th coverlay layer may be stacked on the (1-1)th coverlay layer. The second area may be configured to extend from the first area. The second area may include a second conductive layer or a second coverlay layer. The second conductive layer may be configured to form the same conductive layer as the first conductive layer. The second coverlay layer may be configured to form the same coverlay layer as the (1-1)th coverlay layer.

### [Brief Description of Drawings]

The above and other aspects, features, and advantages of the disclosure will be more apparent from the following detailed description taken in conjunction with the accompanying drawings, in which:
FIG. 1 illustrates a block diagram of an electronic device in a network environment according to various embodiments,
FIG. 2 illustrates a view of an unfolded state of an electronic device according to an embodiment of the disclosure,
FIG. 3 illustrates a view of a folded state of an electronic device according to an embodiment of the disclosure,
FIG. 4 illustrates an exploded perspective view of an electronic device according to an embodiment of the disclosure,
FIG. 5 illustrates a cross-sectional view of a flexible circuit board and an electronic device according to an embodiment of the disclosure,
FIG. 6A and FIG. 6B illustrate cross-sectional views of a part of a flexible circuit board according to an embodiment of the disclosure,
FIG. 7 illustrates a view of a multi-layer structure of a flexible circuit board according to an embodiment of the disclosure,
FIGS. 8A, 8B, 8C, and 8D illustrate views of a manufacturing process of a flexible circuit board according to an embodiment of the disclosure, and
FIG. 9 illustrates a view of a multi-layer structure of a flexible circuit board according to an embodiment of the disclosure.

### [Mode for Carrying out the Invention]

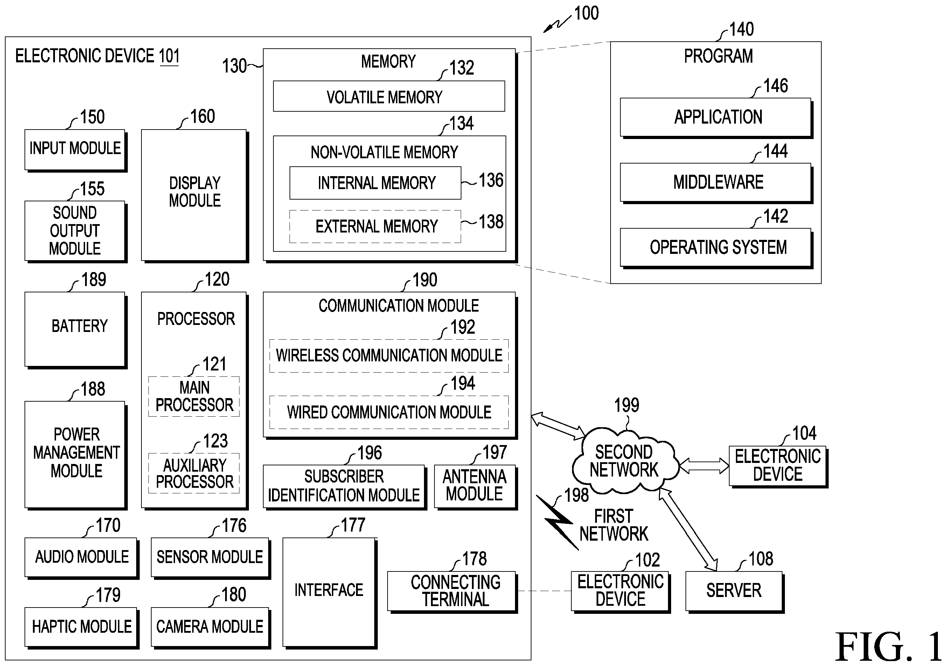

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic dev7ice 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

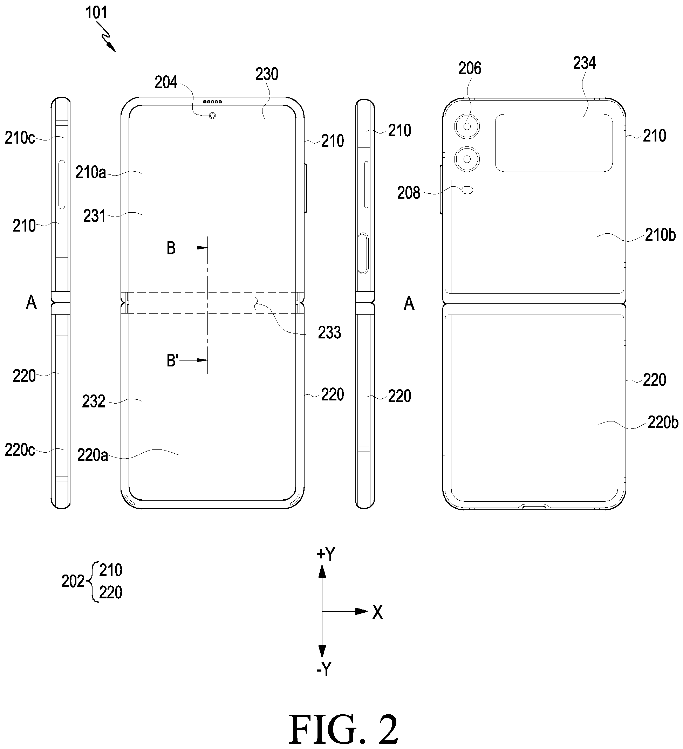

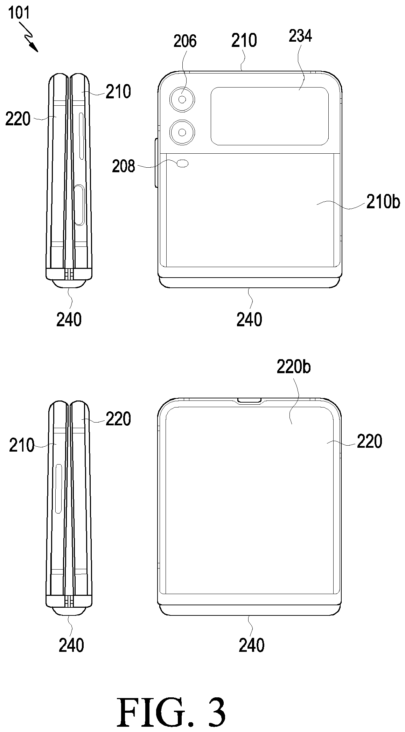

FIG. 2 illustrates a view of an unfolded state of an electronic device according to an embodiment of the disclosure, FIG. 3 illustrates a view of a folded state of an electronic device according to an embodiment of the disclosure.

The configurations of an electronic device 101 in FIG. 2 and FIG. 3 may be partially or entirely the same as the configurations of the electronic device 101 in FIG. 1.

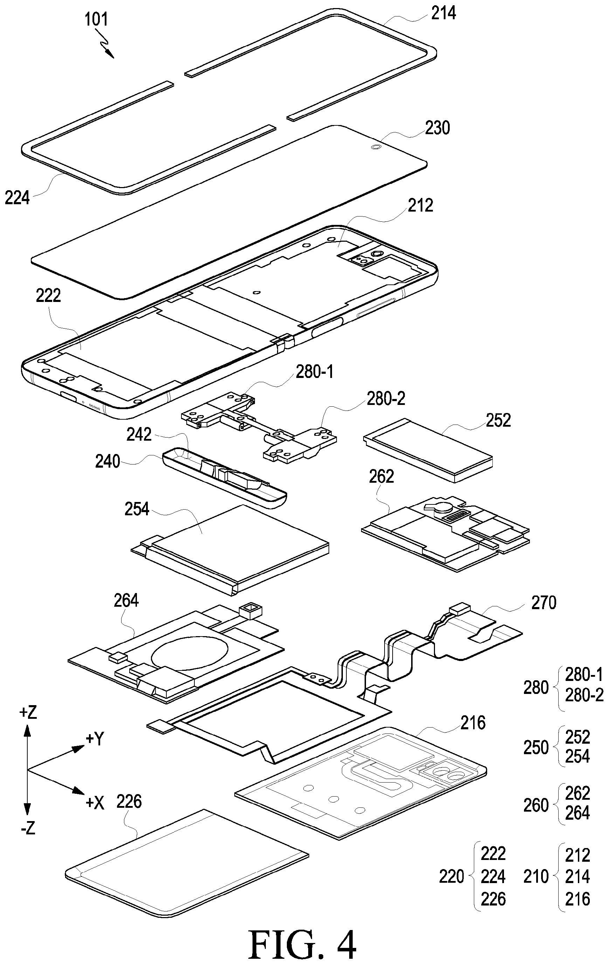

The embodiments of FIG. 2 and FIG. 3 may be combined with the embodiment of FIG. 1 or the embodiments of FIG. 4 to FIG. 9.

Referring to FIG. 2 and FIG. 3, the electronic device 101 may include a housing 202 for accommodating a component (e.g., the hinge structure 280 in FIG. 4) of the electronic device 101 and a flexible display (hereinafter, the display 230) disposed in a space formed by the housing 202. According to an embodiment, the housing 202 may also be a foldable housing. According to an embodiment, the display 230 may also be a foldable display.

According to an embodiment, the housing 202 may include a first housing 210 and a second housing 220 configured to rotate with respect to the first housing 210.

According to an embodiment, the first housing 210 and/or the second housing 220 may form at least a part of the exterior of the electronic device 101. According to an embodiment, a surface, on which the display 230 is visually exposed, is defined as the front surface (e.g., the first front surface 210a and the second front surface 220a) of the electronic device 101 and/or the housing 202. A surface opposite to the front surface is defined as a rear surface (e.g., the first rear surface 210b and the second rear surface 220b) of the electronic device 101. Surfaces for surrounding at least a part of the space between the front surface and the rear surface are defined as the side surfaces (e.g., the first side surface 210c and the second side surface 220c) of the electronic device 101.

According to an embodiment, the first housing 210 may be rotatably connected with respect to the second housing 220 by using a hinge structure (e.g., the hinge structure 280 in FIG. 4). For example, each of the first housing 210 and the second housing 220 may be rotatably connected with respect to the hinge structure 280. Accordingly, the electronic device 101 may be switched to a folded state (e.g., FIG. 3) or an unfolded state (e.g., FIG. 2). The electronic device 101 may be configured such that in a folded state, the first front surface 210a faces the second front surface 220a, and, in an unfolded state, the direction, in which the first front surface 210a is oriented, is substantially the same as the direction in which the second front surface 220a is oriented. For example, in an unfolded state, the first front surface 210a may be positioned on substantially the same plane as the second front surface 220a. According to an embodiment, the second housing 220 may perform a relative motion with respect to the first housing 210.

According to an embodiment, the first housing 210 and the second housing 220 may be arranged at both sides around a folding axis A, and may have a substantially symmetrical shape with respect to the folding axis A. The first housing 210 and the second housing 220 may be configured such that an angle between the first housing 210 and the second housing 220 is changed according to whether a state of the electronic device 101 is an unfolded state, a folded state, or an intermediate state between an unfolded state and a folded state.

According to an embodiment, the electronic device 101 may include a hinge cover 240. At least a part of the hinge cover 240 may be disposed between the first housing 210 and the second housing 220. According to an embodiment, the hinge cover 240 may be covered by a part of the first housing 210 and the second housing 220 or be exposed to the outside of the electronic device 101, according to a state of the electronic device 101. According to an embodiment, the hinge cover 240 may protect a hinge structure (e.g., the hinge structure 280 in FIG. 4) from an impact applied from the outside of the electronic device 101. According to an embodiment, the hinge cover 240 may be interpreted as a hinge housing for protecting the hinge structure (e.g., the hinge structure 280 in FIG. 4).

According to an embodiment, as illustrated in FIG. 2, in case that the electronic device 101 is in an unfolded state, the hinge cover 240 may be covered by the first housing 210 and the second housing 220 and thus may not be exposed. As another embodiment, as illustrated in FIG. 3, in case that the electronic device 101 is in a folded state (e.g., a fully folded state), the hinge cover 240 may be exposed to the outside, between the first housing 210 and the second housing 220. As another embodiment, in case that the first housing 210 and the second housing 220 are in an intermediate state which is folded with a certain angle, the hinge cover 240 may be partially exposed to the outside, between the first housing 210 and the second housing 220. However, in this case, the exposed area may be smaller than that of the fully folded state. In an embodiment, the hinge cover 240 may include a curved surface.

According to an embodiment, the display 230 may visually provide information to the outside (e.g., a user) of the electronic device 101. For example, the display 230 may include a hologram device, or a projector, and a control circuit for controlling a corresponding device. According to an embodiment, the display 230 may include a touch sensor configured to detect a touch, or a pressure sensor configured to measure the intensity of a force generated by the touch.

According to an embodiment, the display 230 may mean a display of which at least a partial area can be transformed into a flat surface or a curved surface. For example, the display 230 may be formed to be variable in response to the relative motion of the second housing 220 with respect to the first housing 210. According to an embodiment, the display 230 may include a folding area 233, a first display area 231 disposed at one side (e.g., the upper side (the +Y-axis direction)) with reference to the folding area 233, and a second display area 232 disposed at the other side (e.g., the lower side (the -Y-axis direction)). According to an embodiment, the folding area 233 may be positioned above a hinge structure (e.g., the hinge structure 280 in FIG. 4). For example, at least a part of the folding area 233 may face the hinge structure 280. According to an embodiment, the first display area 231 may be disposed on the first housing 210 and the second display area 232 may be disposed on the second housing 220. According to an embodiment, the display 230 may be accommodated in the first housing 210 and the second housing 220.

However, the division of the area of the display 230, which is illustrated in FIG. 2, may be exemplary, and the area of the display 230 may also be divided into multiple (e.g., four or more, or two) areas according to a structure or a function thereof.

In addition, in the embodiment illustrated in FIG. 2A, the area of the display 230 may be divided by the folding axis A or the folding area 233 extending parallel to the X-axis. However, in another embodiment, the area of the display 230 may also be divided with reference to another folding area (e.g., a folding area parallel to the Y-axis) or another folding axis (e.g., a folding axis parallel to the Y-axis). According to an embodiment, the display 230 may be coupled to or disposed adjacent to a touch detection circuit, a pressure sensor capable of measuring the intensity (pressure) of touch, and/or a digitizer configured to detect a magnetic field type stylus pen.

According to an embodiment, the electronic device 101 may include a rear display 234. The rear display 234 may be disposed to be oriented in a direction different from that of the display 230. For example, the display 230 may be visually exposed through the front surface (e.g., the first front surface 210a and/or the second front surface 220a) of the electronic device 101, and the rear display 234 may be visually exposed through the rear surface (e.g., the first rear surface 210b) of the electronic device 101.

According to an embodiment, the electronic device 101 may include at least one of camera module 204 or 206, and a flash 208. According to an embodiment, the electronic device 101 may include a front camera module 204 exposed through the front surface (e.g., the first front surface 210a), and/or a rear camera module 206 exposed through the rear surface (e.g., the first rear surface 210b). The camera module 204 or 206 may include one lens or multiple lenses, an image sensor, a flash, and/or an image signal processor. The flash 208 may include a light-emitting diode or a xenon lamp. According to an embodiment, two or more lenses (an infrared camera lens, a wide-angle lens, and a telephoto lens) and image sensors may be arranged on one surface of the electronic device 101. The configuration of the front camera module 204 and/or the rear camera module 206 may be partially or entirely the same as the configuration of the camera module 180 in FIG. 1.

FIG. 4 illustrates an exploded perspective view of an electronic device according to an embodiment of the disclosure.

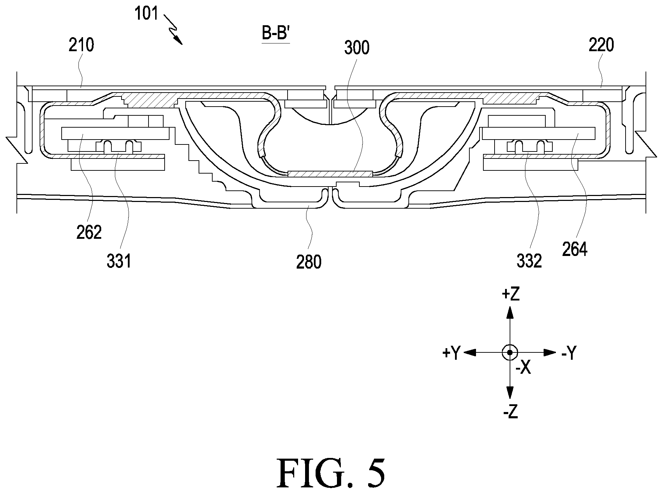

The embodiment of FIG. 4 may be combined with the embodiments of FIG. 1 to FIG. 3 or the embodiments of FIG. 5 to FIG. 9.

Referring to FIG. 4, an electronic device 201 may include a first housing 210, a second housing 220, a display 230, a hinge cover 240, a battery 250, a printed circuit board 260, and a flexible circuit board 270, and a hinge structure 280. The configurations of the first housing 210, the second housing 220, the display 230, and the hinge cover 240 in FIG. 4 may be entirely or partially the same as the configurations of the first housing 210, the second housing 220, the display 230, and the hinge cover 240 in FIG. 2 and/or FIG. 3.

According to an embodiment, the electronic device 101 may include a first support member 212 and a second support member 222. For example, the first housing 210 may include the first support member 212, and the second housing 220 may include the second support member 222. According to an embodiment, the first support member 212 and/or the second support member 222 may support components (e.g., the display 230, the battery 250, and the printed circuit board 260) of the electronic device 101.

According to an embodiment, the first support member 212 and/or the second support member 222 may be formed of a metal material and/or a non-metal (e.g., polymer) material. According to an embodiment, the first support member 212 may be disposed between the display 230 and the battery 250. For example, the display 230 may be coupled to one surface of the first support member 212, and the battery 250 and a printed circuit board 260 may be arranged on the other surface thereof.

According to an embodiment, the electronic device 101 may include a first protective member 214 and a second protective member 224. For example, the first housing 210 may include the first protective member 214, and the second housing 220 may include the second protective member 224. According to an embodiment, the protective members 214 and 224 may protect the display 230 from external impact. For example, the first protective member 214 may surround at least a part of a part (e.g., the first display area 231 in FIG. 2) of the display 230, and the second protective member 224 may surround at least a part of the other a part (e.g., the second display area 232 in FIG. 2) of the display 230. According to an embodiment, the first protective member 214 may be a first cover member, and the second protective member 224 may be a second cover member.

According to an embodiment, the housings 210 and 220 may include a first rear plate 216 and a second rear plate 226. For example, the first housing 210 may include the first rear plate 216 connected to the first support member 212, and the second housing 220 may include the second rear plate 226 connected to the second support member 222. According to an embodiment, the rear plates 216 and 226 may form a part of the exterior of the electronic device 101. For example, the first rear plate 216 may form a first rear surface (e.g., the first rear surface 210b in FIG. 2 and FIG. 3), and the second rear plate 226 may form a second rear surface (e.g., the second rear surface 220b in FIG. 2 and FIG. 3). According to an embodiment, a first battery 252 and a first printed circuit board 262 may be arranged between the first support member 212 and the first rear plate 216, and a second battery 254 and a second printed circuit board 264 may be arranged between the second support member 222 and the second rear plate 226.

According to an embodiment, the hinge cover 240 may accommodate at least a part of the hinge structure 280. For example, the hinge cover 240 may include an accommodation groove 242 for accommodating the hinge structure 280. According to an embodiment, the hinge cover 240 may be coupled to the hinge structure 280. According to an embodiment, in case that the electronic device 101 is in an unfolded state, at least a part of the hinge cover 240 may be positioned between the hinge structure 280 and the housings 210 and 220.

According to an embodiment, the battery 250 may be a device for supplying electric power to at least one element of the electronic device 101, and may include a non-rechargeable primary cell, a rechargeable secondary cell, or a fuel cell. The battery 250 may also be integrally disposed inside the electronic device 101, or may also be disposed to be detachable/attachable from/to the electronic device 101. According to an embodiment, the battery 250 may include a first battery 252 disposed in the first housing 210 and a second battery 254 disposed in the second housing 220. For example, the first battery 252 may be disposed on the first support member 212, and the second battery 254 may be disposed on the second support member 222.

According to an embodiment, a processor (e.g., the processor 120 in FIG. 1), a memory (e.g., the memory 130 in FIG. 1), and/or an interface (e.g., the interface 177 in FIG. 1) may be mounted on the printed circuit board 260. According to an embodiment, the printed circuit board 260 may include the first printed circuit board 262 disposed in the first housing 210, and the second printed circuit board 264 disposed in the second housing 220.

According to an embodiment, the flexible circuit board 270 may electrically connect a component (e.g., the first printed circuit board 262) positioned in the first housing 210 and a component (e.g., the second printed circuit board 264) positioned in the second housing 220. According to an embodiment, the flexible circuit board 270 may be a flexible printed circuit board (FPCB). According to an embodiment, at least a part of the flexible circuit board 270 may cross the hinge cover 240 and/or the hinge structure 280. For example, a part of the flexible circuit board 270 may be disposed in the first housing 210, and the other a part may be disposed in the second housing 220. According to an embodiment, the flexible circuit board 270 may be connected to an antenna or connected to the display 230. According to an embodiment, the flexible circuit board 270 may have at least a portion configured to be bendable.

According to an embodiment, the hinge structure 280 may be connected to the first housing 210 and the second housing 220. According to an embodiment, the first housing 210 may rotate with respect to the second housing 220 by using the hinge structure 280. According to an embodiment, the hinge structure 280 may be connected such that the first housing 210 and the second housing 220 rotate from a folded state (e.g., FIG. 3) to an unfolded state (e.g., FIG. 2).

According to an embodiment, the hinge structure 280 may include multiple hinge structures 280-1 and 280-2 arranged in parallel. For example, the hinge structure 280 may include a first hinge structure 280-1 and a second hinge structure 280-2 spaced apart from the first hinge structure 280-1. According to an embodiment, the first hinge structure 280-1 may be symmetrical to the second hinge structure 280-2 with respect to the longitudinal direction (e.g., the Y-axis direction) of the electronic device 101.

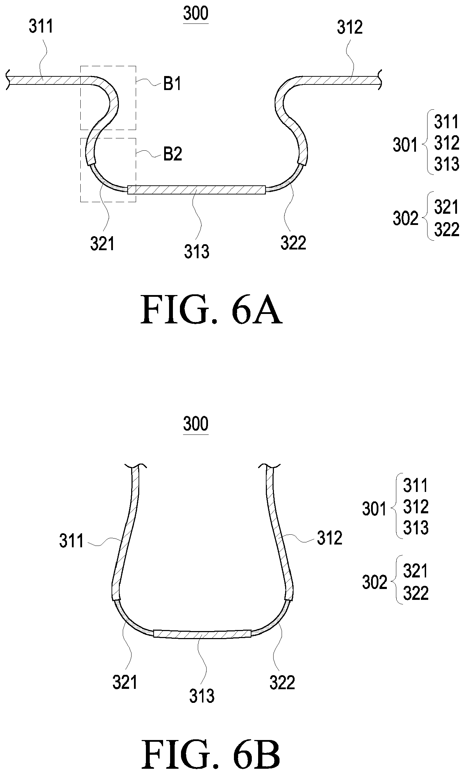

FIG. 5 illustrates a cross-sectional view of a flexible circuit board and an electronic device according to an embodiment of the disclosure, FIG. 6A and FIG. 6B illustrate cross-sectional views of a part of a flexible circuit board according to an embodiment of the disclosure.

FIG. 5 illustrates a cross-sectional view cut along line B-B' in FIG. 2. FIG. 6A illustrates a cross-sectional view of a flexible circuit board in case that an electronic device is in an unfolded state (e.g., FIG. 2). FIG. 6B illustrates a cross-sectional view of a flexible circuit board in case that an electronic device is in a folded state (e.g., FIG. 3).

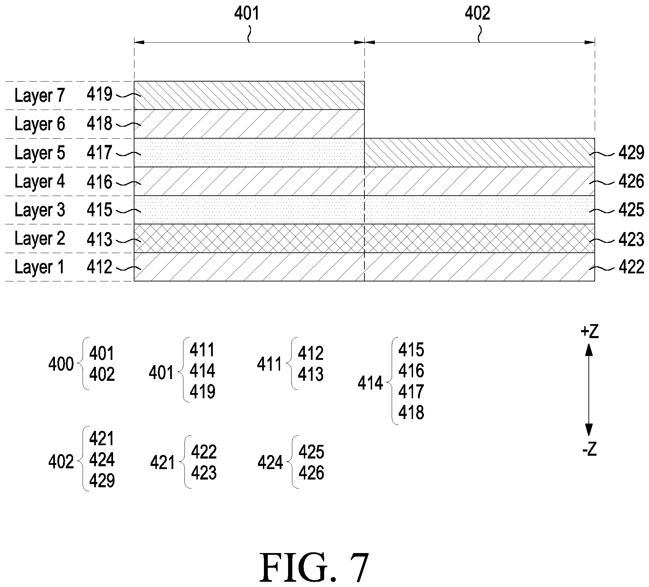

The embodiments of FIG. 5 to FIG. 6B may be combined with the embodiments of FIG. 1 to FIG. 4 or the embodiments of FIG. 7 to FIG. 9.

Referring to FIG. 5 to FIG. 6B, an electronic device 101 (e.g., the electronic device 101 in FIG. 1 to FIG. 4) may include a first housing 210, a second housing 220, a first printed circuit board 262, a second printed circuit board 264, a hinge structure 280, or a flexible circuit board 300.

The configurations of the first housing 210, the second housing 220, the first printed circuit board 262, the second printed circuit board 264, the hinge structure 280, or the flexible circuit board 300 in FIG. 5 to FIG. 6B may be partially or entirely the same as the configurations of the first housing 210, the second housing 220, the first printed circuit board 262, the second printed circuit board 264, the hinge structure 280, or the flexible circuit board 270 in FIG. 4.

According to an embodiment, the flexible circuit board 300 may be a flexible printed circuit board (FPCB). The flexible circuit board 300 may have at least a portion disposed adjacent to the hinge structure 280.

According to an embodiment, the flexible circuit board 300 may be disposed to cross the first housing 210, the hinge structure 280, and the second housing 220 in a direction perpendicular to a folding axis (e.g., the folding axis A in FIG. 2) of the electronic device 101.

According to an embodiment, the flexible circuit board 300 may electrically connect the first printed circuit board 262 and the second printed circuit board 264. According to an embodiment, the flexible circuit board 300 may also be defined and/or referred to as a connector-to-connector flexible printed circuit board (a C2C FPCB) for connecting the first printed circuit board 262 and the second printed circuit board 264.

According to an embodiment, the flexible circuit board 300 may include a first connector 331 to be connected to the first printed circuit board 262, or a second connector 332 to be connected to the second printed circuit board 264. For example, the first connector 331 may be disposed in a (1-1)th area (e.g., the (1-1)th area 311 in FIG. 6A and FIG. 6B) to be described later, and the second connector 332 may be disposed in a (1-2)th area (e.g., the (1-2)th area 312 in FIG. 6A and FIG. 6B) to be described later.

According to an embodiment, the flexible circuit board 300 may have at least a portion configured to be bendable. For example, in case that the electronic device 101 is in an unfolded state (e.g., FIG. 2 or FIG. 6A), or a folded state (e.g., FIG. 3 or FIG. 6B), at least a portion of the flexible circuit board 300 may be folded or unfolded.

According to an embodiment, the flexible circuit board 300 may be a multi-layered circuit board in which one or more conductive layers or one or more insulation layers are stacked on each other. For example, the flexible circuit board 300 may include a multi-layer structure. For example, the at least one conductive layer of the flexible circuit board 300 may include a conductive path for electrically connecting the first printed circuit board 262 and the second printed circuit board 264.

According to an embodiment, the conductive path may be a configuration formed on the at least one conductive layer in order to deliver electric power (or power supply) provided from a power management module (e.g., the power management module 188 in FIG. 1), or a signal provided from a processor (e.g., the processor 120 in FIG. 1).

According to an embodiment, the conductive path may be a configuration for delivering a communication signal provided from an antenna module (e.g., the antenna module 197 in FIG. 1) to a communication module (e.g., the communication module 190 in FIG. 1), or a communication signal of a communication module to an antenna module.

Referring to FIG. 6A and FIG. 6B, the flexible circuit board 300 may include a first area 301 or a second area 302 extending from the first area 301. According to an embodiment, the first area 301 may also be defined as an area extending from the second area 302.

According to an embodiment, the first area 301 may include a (1-1)th area 311, a (1-2)th area 312, or a (1-3)th area 313.

According to an embodiment, at least a portion of the (1-1)th area 311 may be disposed on the first housing 210 or disposed inside the first housing 210. According to an embodiment, at least a portion of the (1-2)th area 312 may be disposed on the second housing 220 or disposed inside the second housing 220. According to an embodiment, at least a portion of the (1-3)th area 313 may be disposed on the hinge structure 280 or disposed adjacent to the hinge structure 280.

According to an embodiment, the second area 302 may include a (2-1)th area 321 or a (2-2)th area 322.

According to an embodiment, at least a portion of the (2-1)th area 321 may be disposed on the first housing 210 or disposed inside the first housing 210. According to an embodiment, at least a portion of the (2-2)th area 322 may be disposed on the second housing 220 or disposed inside the second housing 220. According to an embodiment, at least one of the (2-1)th area 321 or the (2-2)th area 322 may be disposed on the hinge structure 280 or disposed adjacent to the hinge structure 280.

According to an embodiment, the (1-1)th area 311, the (1-2)th area 312, and the (1-3)th area 313 may have substantially the same structure (e.g., the same multi-layer structure). According to an embodiment, the (1-1)th area 311 may be connected to the (2-1)th area 321, the (1-2)th area 312 may be connected to the (2-2)th area 322, and the (1-3)th area 313 may be connected to the (2-1)th area 321 and the (2-2)th area 322.

According to an embodiment, the (2-1)th area 321 and the (2-2)th area 322 may have substantially the same structure (e.g., the same multi-layer structure). According to an embodiment, the (2-1)th area 321 may be connected to the (1-1)th area 311 and the (1-3)th area 313, and the (2-2)th the area 322 may be connected to the (1-2)th area 312 and the (1-3)th area 313.

According to an embodiment, the number of multi-layers in the first area 301 may be different from the number of multi-layers in the second area 302. Detailed descriptions thereof will be described later.

For example, the flexible circuit board 300 may be defined as having a structure in which the (1-1)th area 311, the (2-1)th area 321, the (1-3)th area 313, the (2-2)th area 322, and the (1-2)th area 312 are connected to each other in the sequential order or connected in the reverse order.

According to an embodiment, in case that the electronic device 101 is in an unfolded state (e.g., FIG. 2 or FIG. 6A), at least a portion of the (1-1)th area 311 and/or the (1-2)th area 312 may be deformed by bending or folding. According to an embodiment, in case that the electronic device 101 is in an unfolded state (e.g., FIG. 3 or FIG. 6A), at least a portion of the (1-1)th area 311 and/or the (1-2)th area 312 may be deformed by bending or folding.

As an electronic device is repeatedly unfolded or folded, a repeated bending load may be applied to a deformable portion (e.g., the first portion B1) of the flexible circuit board. At least a portion of the conductive layer, which is positioned at a first portion B1, may be damaged by being repeatedly stretched or contracted by the bending load. In addition, in case that an electronic device is switched from a folded state to an unfolded state, a second portion B2 of the flexible circuit board, which is adjacent to the first portion B1, may be pressed by the first portion B1, so that a repulsive force may be formed in the second portion B2. Accordingly, in case that an electronic device is switched from a folded state to an unfolded state, noise may be generated in the second portion B2 due to the repulsive force.

According to an embodiment, the flexible circuit board 300 may be configured to provide a multi-layer structure of the first area 301 and a multi-layer structure of the second area 302 which are different, thereby reducing damage occurrence of the conductive layer of the first portion B1 or reducing noise occurrence in the second portion B2. Detailed descriptions thereof will be described later.

FIG. 7 illustrates a view of a multi-layer structure of a flexible circuit board according to an embodiment of the disclosure.

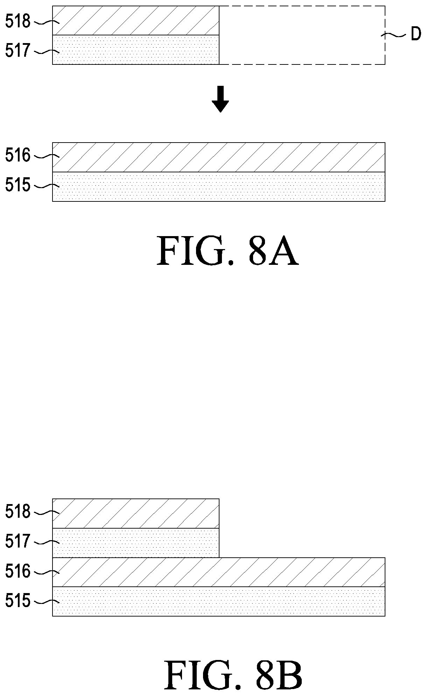

The embodiment of FIG. 7 may be combined with the embodiments of FIG. 1 to FIG. 6B or the embodiments of FIG. 8A to FIG. 9.

Referring to FIG. 7, an electronic device 101 (e.g., the electronic device 101 in FIG. 1 to FIG. 5) may include a flexible circuit board 400 (e.g., the flexible circuit board 300 in FIG. 5 to FIG. 6B). According to an embodiment, the flexible circuit board 400 may include a first area 401 or a second area 402.

The configurations of the first area 401 or the second area 402 in FIG. 7 may be partially or entirely the same as the configurations of the first area 301 or the second area 302 in FIG. 5 to FIG. 6B.

The exemplary embodiment illustrated in FIG. 7 may be for explaining a multi-layer structure of the first area 401 and the second area 402 of the flexible circuit board 400. The first area 301, the (1-1)th area 311, the (1-2)th area 312, or (1-3)th area 313 in FIG. 6A and FIG. 6B may have a multi-layer structure substantially identical or similar to that of the first area 401 in FIG. 7. The second area 302, the (2-1)th area 321, or the (2-2)th area 322 in FIG. 6A and FIG. 6B may have a multi-layer structure substantially identical or similar to that of the second area 402 in FIG. 7.

Referring to FIG. 7, the thickness (e.g., in thickness direction of the electronic device or the flexible circuit board (e.g., the Z-axis direction in FIG. 7)) of the first area 401 be greater than the thickness of the second area 402.

According to an embodiment, the first area 401 may have seven layers, and the second area 402 may have five layers, but it is not limited thereto. According to an embodiment, the number of multi-layers in the first area 401 may be greater than the number of multi-layers in the second area 402.

According to one embodiment, the flexible circuit board 400 may include a first layer (Layer 1) to a seventh layer (Layer 7). For example, the first area 401 may include the first layer (Layer 1) to the seventh layer (Layer 7). In addition, the second area 402 may include the first layer (Layer 1) to a fifth layer (Layer 5). For example, the number of multi-layers in the second area 402 may be smaller than the number of multi-layers in the first area 401.

According to an embodiment, the first area 401 may include a first FCCL layer 411, a first coverlay layer 414, or a first film layer 419. According to an embodiment, the first FCCL layer 411 may also be defined and/or referred to as a first flexible copper clad laminate.

According to an embodiment, the second area 402 may include a second FCCL layer 421, a second coverlay layer 424, or a second film layer 429. According to an embodiment, the second FCCL layer 421 may also be defined and/or referred to as a second flexible copper clad laminate.

According to an embodiment, the first FCCL layer 411 may include at least one (1-1)th insulation layer 412 and at least one first conductive layer 413 stacked on the at least one (1-1)th insulation layer 412. According to an embodiment, the (1-1)th insulation layer 412 may be a polypropylene glycol (PPG) or polyimide (PI)-based substrate layer. According to an embodiment, the at least one first conductive layer 413 may be a metal thin plate (e.g., copper (Cu)) stacked on one surface (e.g., the surface oriented in the +Z-axis direction in FIG. 7) of the at least one (1-1)th insulation layer 412.

According to an embodiment, the second FCCL layer 421 may include at least one (2-1)th insulation layer 422 and at least one second conductive layer 423 stacked on the at least one (2-1)th insulation layer 422. According to an embodiment, the (2-1)th insulation layer 422 may be a polypropylene glycol (PPG) or polyimide (PI)-based substrate layer. According to an embodiment, the at least one second conductive layer 423 may be a metal thin plate (e.g., copper (Cu)) stacked on one surface (e.g., the surface oriented in the +Z-axis direction in FIG. 7) of the at least one (2-1)th insulation layer 422.

According to an embodiment, the at least one (1-1)th insulation layer 412 and the at least one (2-1)th insulation layer 422 may be formed as a substantially identical insulation layer. For example, the at least one (1-1)th insulation layer 412 and the at least one (2-1)th insulation layer 422 may be defined and/or interpreted as a substantially identical (or one) insulation layer.

According to an embodiment, the at least one first conductive layer 413 and the at least one second conductive layer 423 may be formed as a substantially identical conductive layer. For example, the at least one first conductive layer 413 and the at least one second conductive layer 423 may be defined and/or interpreted as a substantially identical (or one) conductive layer.

According to an embodiment, the first layer (Layer 1) may include the at least one (1-1)th insulation layer 412 and the at least one (2-1)th insulation layer 422. According to an embodiment, the thickness of the at least one (1-1)th insulation layer 412 and the thickness of the at least one (2-1)th insulation layer 422 (e.g., the thickness in the Z-axis direction in FIG. 7) may be about 11 micro meter (um) to about 13 um, for example, about 12 um.

According to an embodiment, the second layer (Layer 2) may include the at least one first conductive layer 413 and the at least one second conductive layer 423. According to an embodiment, the thickness of the at least one first conductive layer 413 and the thickness of the at least one second conductive layer 423 (e.g., the thickness in the Z-axis direction in FIG. 7) may be about 11 micro meter (um) to about 13 um, for example, about 12 um.

According to an embodiment, the first coverlay layer 414 may be stacked one surface (e.g., the surface oriented in the +Z-axis direction in FIG. 7) of the first FCCL layer 411, or one surface of the first conductive layer 413. According to an embodiment, the first coverlay layer 414 may include (1-1)th coverlay layers 415 and 416 or (1-2)th coverlay layers 417 and 418.

According to an embodiment, the (1-1)th coverlay layers 415 and 416 may include a (1-1)th adhesive layer 415 stacked on one surface (e.g., the surface oriented in the +Z-axis direction in FIG. 7) of the first conductive layer 413, or a (1-2)th insulation layer 416 stacked on one surface of (1-1)th adhesive layer 415.

According to an embodiment, the (1-1)th adhesive layer 415 may include an adhesive or a double-sided tape. According to an embodiment, the (1-1)th adhesive layer 415 may be configured to bond the first conductive layer 413 and the (1-2)th insulation layer 416.

According to an embodiment, the (1-2)th insulation layer 416 may be a polypropylene glycol (PPG) or polyimide (PI)-based substrate layer.

According to an embodiment, the (1-2)th coverlay layers 417 and 418 may include a (1-2)th adhesive layer 417 stacked on one surface (e.g., the surface oriented in the +Z-axis direction in FIG. 7) of the (1-2)th insulation layer 416, or a (1-3)th insulation layer 418 stacked on one surface of (1-2)th adhesive layer 417.

According to an embodiment, the (1-2)th adhesive layer 417 may include an adhesive or a double-sided tape. According to an embodiment, the (1-2)th adhesive layer 417 may be configured to bond the (1-2)th insulation layer 416 and the (1-3)th insulation layer 418.

According to an embodiment, the (1-3)th insulation layer 418 may be a polypropylene glycol (PPG) or polyimide (PI)-based substrate layer.

According to an embodiment, the second coverlay layer 424 may be stacked one surface (e.g., the surface oriented in the +Z-axis direction in FIG. 7) of the second FCCL layer 421, or one surface of the second conductive layer 423.

According to an embodiment, the second coverlay layer 424 may include a second adhesive layer 425 stacked on one surface (e.g., the surface oriented in the +Z-axis direction in FIG. 7) of the second conductive layer 423, or a (2-2) insulation layer 426 stacked on one surface of the second adhesive layer 425.

According to an embodiment, the second adhesive layer 425 may include an adhesive or a double-sided tape. According to an embodiment, the second adhesive layer 425 may be configured to bond the second conductive layer 423 and the (2-2)th insulation layer 426.

According to an embodiment, the (2-2)th insulation layer 426 may be a polypropylene glycol (PPG) or polyimide (PI)-based substrate layer.

According to an embodiment, the (1-1)th adhesive layer 415 and the second adhesive layer 425 may be formed as a substantially identical adhesive layer. For example, the (1-1)th adhesive layer 415 and the second adhesive layer 425 may be defined and/or interpreted as a substantially identical (or one) adhesive layer.

According to an embodiment, the (1-2)th insulation layer 416 and the (2-2)th insulation layer 426 may be formed as a substantially identical insulation layer. For example, the (1-2)th insulation layer 416 and the (2-2)th insulation layer 426 may be defined and/or interpreted as a substantially identical (or one) insulation layer.

According to an embodiment, the third layer (Layer 3) may include the (1-1)th adhesive layer 415 and the second adhesive layer 425. According to an embodiment, the thickness of the (1-1)th adhesive layer 415 and the thickness of the second adhesive layer 425 (e.g., the thickness in the Z-axis direction in FIG. 7) may be about 9 micro meter (um) to about 11 um, for example, about 10 um.

According to an embodiment, the fourth layer (Layer 4) may include the (1-2)th insulation layer 416 and the (2-2)th insulation layer 426. According to an embodiment, the thickness of the (1-2)th insulation layer 416 and the thickness of the (2-2)th insulation layer 426 (e.g., the thickness in the Z-axis direction in FIG. 7) may be about 6.5 micro meter (um) to about 8.5 um, for example, about 7.5 um.

According to an embodiment, the (1-1)th adhesive layer 415 of the first area 401 and the second adhesive layer 425 of the second area 402, and the (1-2)th insulation layer 416 of the first area 401 and the (2-2)th insulation layer 426 of the second area 402 may be formed as a substantially identical coverlay layer. For example, the (1-1)th adhesive layer 415 and the second adhesive layer 425, and the (1-2)th insulation layer 416 and the (2-2)th insulation layer 426 may be defined and/or interpreted as a substantially identical (or one) coverlay layer. For example, the (1-1)th coverlay layer 415 and 416 of the first area 401 and the second coverlay layer 425 and 426 of the second area 402 may be defined and/or interpreted as a substantially identical (or one) coverlay layer.

According to an embodiment, the second area 402 may not have coverlay layers corresponding to the (1-2)th coverlay layers 417 and 418 of the first area 401, compared to the first area 401. In other words, the first area 401 may include additional coverlay layers (e.g., the (1-2)th coverlay layers 417 and 418), compared to the second area 402.

According to an embodiment, the first film layer 419 may be stacked on one surface (e.g., the surface oriented in the +Z-axis direction in FIG. 7) of the (1-2)th coverlay layers 417 and 418. For example, the first film layer 419 may be stacked on one surface of the (1-3)th insulation layer 418. According to an embodiment, the first film layer 419 may be an EMI film for shielding electromagnetic waves generated from electronic components around the flexible circuit board 400.

According to an embodiment, the second film layer 429 may be stacked on one surface (e.g., the surface oriented in the +Z-axis direction in FIG. 7) of the second coverlay layer 425 and 426. For example, the second film layer 429 may be stacked on one surface of the (2-2)th insulation layer 426. According to an embodiment, the second film layer 429 may be an EMI film for shielding electromagnetic waves generated from electronic components around the flexible circuit board 400.

According to an embodiment, the fifth layer (Layer 5) may include the (1-2)th adhesive layer 417 and the second film layer 429. According to an embodiment, the thickness (e.g., the thickness in the Z-axis direction in FIG. 7) of the (1-2)th adhesive layer 417 may be about 7 micro meter (um) to about 9 um, for example, about 8 um. According to an embodiment, the thickness (e.g., the thickness in the Z-axis direction in FIG. 7) of the second film layer 429 may be about 14.5 to 16.5 um, for example, about 15.5 um.

According to an embodiment, the sixth layer (Layer 6) may include the (1-3)th insulation layer 418. According to an embodiment, the thickness (e.g., the thickness in the Z-axis direction in FIG. 7) of the (1-3)th insulation layer 418 may be about 4 micro meter (um) to about 6 um, for example, about 5 um.

According to an embodiment, the seventh layer (Layer 7) may include the first film layer 419. According to an embodiment, the thickness (e.g., the thickness in the Z-axis direction in FIG. 7) of the first film layer 419 may be about 14.5 micro meter (um) to about 16.5 um, for example, about 15.5 um.

According to an embodiment, the first area 401 may include additional coverlay layers (e.g., the (1-2)th coverlay layers 417 and 418), compared to the second area 402. Accordingly, the thickness (e.g., the thickness in the Z-axis direction in FIG. 7) of the first area 401 may be greater than the thickness of the second area 402.

According to an embodiment, the second area 402 may have a thickness thinner than the first area 401, and thus may have rigidity lower than the first area 401. According to an embodiment, as an electronic device (e.g., the electronic device 101 in FIG. 2 to FIG. 5) is repeatedly switched (e.g., folded or unfolded), since the second area 402 has a relatively lower rigidity than the first area 401, a small repulsive force may be formed. Accordingly, noise generated in a second portion (e.g., the second portion B2 in FIG. 6A) of the second area 402 may be reduced.

In addition, the first area 401 may have a thickness thicker than the second area 402, and thus may have rigidity higher than the second area 402. According to an embodiment, the first area 401 may include additional coverlay layers (e.g., the (1-2)th coverlay layers 417 and 418), compared to the second area 402, and thus, in case that an electronic device (e.g., the electronic device 101 in FIG. 2 to FIG. 5) is repeatedly switched (e.g., folded or unfolded), the repeated load delivered to the first conductive layer 413 may be relieved. For example, the first area 401 may include the (1-2)th coverlay layer 417 and 418, and thus, in case that the flexible circuit board 400 is switched, a neutral surface or a neutral axis for shear deformation may be formed on the first conductive layer 413. Accordingly, in case that an electronic device is repeatedly switched, damage occurrence of the first conductive layer 413 can be reduced or prevented.

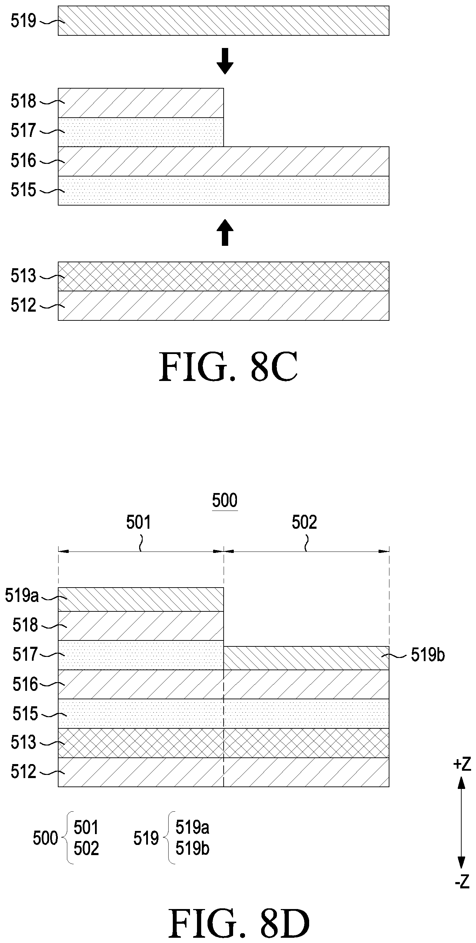

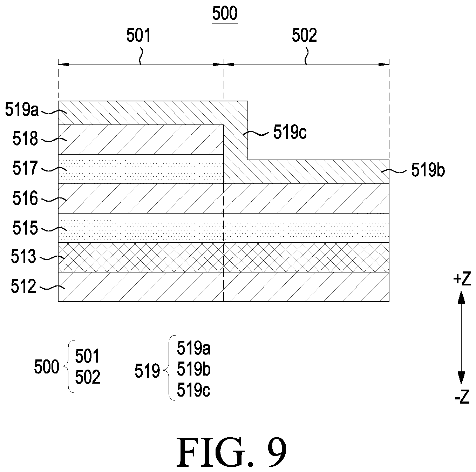

FIGS. 8A, 8B, 8C, and 8D illustrate views of a manufacturing process of a flexible circuit board according to an embodiment of the disclosure, and FIG. 9 illustrates a view of a multi-layer structure of a flexible circuit board according to an embodiment of the disclosure.

The embodiments of FIG. 8A to FIG. 9 may be combined with the embodiments of FIG. 1 to FIG. 7.

Referring to FIG. 8A to FIG. 9, a flexible circuit board 500 of an electronic device (e.g., the electronic device 101 in FIG. 1 to FIG. 5) may include a first insulation area 512, a first conductive area 513, a first adhesive area 515, a second insulation area 516, a second adhesive area 517, a third insulation area 518, or a film area 519.

Referring to FIG. 8A and FIG. 8B, a manufacturing process of the flexible circuit board may include a process of coupling or a process of laminating the first coverlay area 515 and 516 and the second coverlay area 517 and 518.

According to an embodiment, the second coverlay area 517 and 518 may have a width smaller than the first coverlay area 515 and 516. For example, as illustrated in FIG. 8A, the second coverlay area 517 and 518 may be defined as the remaining areas in which a partial area D thereof has been removed therefrom, compared to the first coverlay area 515 and 516, or alternatively, may be defined as having a small size minus the size of the partial area D, compared to the first coverlay area 515 and 516.

According to an embodiment, the first coverlay area 515 and 516 may include the first adhesive area 515 and the second insulation area 516. According to an embodiment, the first adhesive area 515 may include a (1-1)th adhesive layer (e.g., the (1-1)th adhesive layer 415 in FIG. 7) and a secondadhesive layer (e.g., the second adhesive layer 425 in FIG. 7). In addition, the first adhesive area 515 may form a third layer (e.g., the third layer (Layer 3) in FIG. 7) of a flexible circuit board (e.g., the flexible circuit board 400 in FIG. 7). According to an embodiment, the second insulation area 516 may include a (1-2)th insulation layer (e.g., the (1-2)th insulation layer 416 in FIG. 7) and a (2-2)th insulation layer (e.g., the (2-2)th insulation layer 426 in FIG. 7). In addition, the second insulation area 516 may form a fourth layer (e.g., the fourth layer (Layer 4) in FIG. 7) of the flexible circuit board.

According to an embodiment, the second coverlay area 517 and 518 may include the second adhesive area 517 and the third insulation area 518. According to an embodiment, the second adhesive area 517 may include a (1-2)th adhesive layer (e.g., the (1-2)th adhesive layer 417 in FIG. 7). In addition, the second adhesive area 517 may form at least a part of a fifth layer (e.g., the fifth layer (Layer 5) in FIG. 7) of the flexible circuit board. According to an embodiment, the third insulation area 518 may include a (1-3)th insulation layer (e.g., the (1-3)th insulation layer 418 in FIG. 7). In addition, the third insulation area 518 may form at least a part of a sixth layer (e.g., the sixth layer (Layer 6) in FIG. 7) of the flexible circuit board.

Referring to FIG. 8C and FIG. 8D, a manufacturing process of the flexible circuit board may include a process of coupling or a process of laminating the FCCL area 512 and 513 and the film area 519 to or on the lamination illustrated in FIG. 8B.

According to an embodiment, the FCCL area 512 and 513 may include the first insulation area 512 and the conductive area 513. According to an embodiment, the first insulation area 512 may include a (1-1)th insulation layer (e.g., the (1-1)th insulation layer 412 in FIG. 7) and a (2-1)th insulation layer (e.g., the (2-1)th insulation layer 422 in FIG. 7). In addition, the first insulation area 512 may form a first layer (e.g., the first layer (Layer 1) in FIG. 7) of the flexible circuit board. According to an embodiment, the conductive area 513 may include a first conductive layer (e.g., the first conductive layer 413 in FIG. 7) and a second conductive layer (e.g., the second conductive layer 423 in FIG. 7). In addition, the conductive area 513 may form a second layer (e.g., the second layer (Layer 2) in FIG. 7) of the flexible circuit board.

According to an embodiment, the film area 519 may include a first film area 519a and a second film area 519b. According to an embodiment, the first film area 519a may include a first film layer (e.g., the first film layer 419 in FIG. 7). According to an embodiment, the first film area 519a may form a seventh layer (e.g., the seventh layer (Layer 7) in FIG. 7) of the flexible circuit board. According to an embodiment, the second film area 519b may include a second film layer (e.g., the second film layer 429 in FIG. 7). According to an embodiment, the second film area 519b may form at least a part of a fifth layer (e.g., the fifth layer (Layer 5) in FIG. 7) of the flexible circuit board.

Referring to FIG. 8D an FIG. 9, the flexible circuit board 500, on which the aforementioned lamination process has been completed, may include a first area 501 (e.g., the first area 401 in FIG. 7) and a second area 502 (e.g., the second area 402 in FIG. 7).

Referring to FIG. 8D, the film area 519 may have the first film area 519a and the second film area 519b which are formed as separate areas. For example, in case that the film area 519 is stacked, the film area 519 may be divided into the first film area 519a and the second film area 519b to be stacked on the third insulation area 518 and the second insulation area 516, respectively.

Referring to FIG. 9, the film area 519 may have the first film area 519a and the second film area 519b which are formed as an integral area. For example, the first film area 519a and the second film area 519b may be connected through a third film area 519c. The first film area 519a, the second film area 519b, and the third film area 519c may be integrally formed. For example, in case that the film area 519 is stacked, a part of the film area 519 may be stacked to cover a part of the side surface of the second adhesive area 517 and a part of the side surface of the third insulation area 518 so as to form the third film area 519c.

An electronic device (for example, a mobile terminal) may include a display having a flat surface or a flat surface and a curved surface. An electronic device including an existing type of display may require another terminal in order to implement a screen larger than the size of the electronic device, due to a fixed structure of a display. Therefore, an electronic device including a foldable or a rollable display is being researched.

An electronic device including a foldable display may include at least one flexible circuit board (e.g., an FPCB) disposed to cross a folding axis of the foldable electronic device. The flexible circuit board may be configured to electrically connect a circuit board (e.g., a PCB) or an electrical component disposed in a housing of one side thereof and a circuit board or an electrical component disposed in a housing of the other side.

The flexible circuit board may be configured such that at least a part thereof is unfolded or folded in case that an electronic device is folded or unfolded. As at least a part of the flexible circuit board is repeatedly deformed, a conductive path of the flexible circuit board may be damaged by loads repeatedly applied thereto. In addition, in case that the flexible circuit board is repeatedly deformed, noise may be generated due to a repulsive force formed in a portion of the flexible circuit board.

According to an embodiment of the disclosure, it may be possible to provide a flexible circuit board capable of preventing damage of a conductive layer of the flexible circuit board, and an electronic device including same.

According to an embodiment of the disclosure, it may be possible to provide a flexible circuit board capable of reducing noise generation in a portion of the flexible circuit board in case that at least a part of the flexible circuit board is folded or unfolded, and an electronic device including same.

However, the problem to be solved in the disclosure is not limited to the mentioned problem, and may be variously expanded within a scope not deviating from the idea and the range of the disclosure.

A flexible circuit board and an electronic device including same according to an embodiment of the disclosure may be provided to relieve a load applied to a conductive layer in case that the flexible circuit board is repeatedly deformed by bending.

A flexible circuit board and an electronic device including same according to an embodiment of the disclosure may reduce noise generated in a portion of the flexible circuit board in case that the flexible circuit board is deformed by bending.

The effects obtainable from the disclosure are not limited to the effects mentioned above, and other effects not mentioned will be clearly understood by a person skilled in the art, to which the disclosure belongs, from the descriptions below.

According to an embodiment of the disclosure, an electronic device (e.g., the electronic device 101 in FIG. 1 to FIG. 5) may include a housing (e.g., the housing 202 in FIG. 2), a hinge structure (e.g., the hinge structure 280 in FIG. 4), or a flexible circuit board (e.g., the flexible circuit board 300 in FIG. 5 to FIG. 6B, or the flexible circuit board 400 in FIG. 7). The housing may include a first housing (e.g., the first housing 210 in FIG. 2 to FIG. 5) and a second housing (e.g., the second housing 220 in FIG. 2 to FIG. 5). The hinge structure may be configured to rotatably connect the first housing and the second housing. The flexible circuit board may be at least partially disposed in the hinge structure. The flexible circuit board may include a first area (e.g., the first area 401 in FIG. 7) or a second area (e.g., the second area 402 in FIG. 7). The first area may be at least partially configured to be bendable. The first area may include a first conductive layer (e.g., the first conductive layer 413 in FIG. 7), a (1-1)th coverlay layer (e.g., the (1-1)th coverlay layer 415 and 416 in FIG. 7), or a (1-2)th coverlay layer (e.g., the (1-2)th coverlay layer 417 and 418 in FIG. 7). The (1-1)th coverlay layer may be stacked on the first conductive layer. The (1-2)th coverlay layer may be stacked on the (1-1)th coverlay layer. The second area may be configured to extend from the first area. The second area may include a second conductive layer (e.g., the second conductive layer 423 in FIG. 7) or a second coverlay layer (e.g., the second coverlay layer 425 and 426 in FIG. 7). The second conductive layer may be configured to form the same conductive layer as the first conductive layer. The second coverlay layer may be configured to form the same coverlay layer as the (1-1)th coverlay layer.

According to an embodiment, the thickness of the first area may be greater than the thickness of the second area.

According to an embodiment, the flexible circuit board may further include a (1-1)th insulation layer (e.g., the (1-1)th insulation layer 412 in FIG. 7), or a (2-1)th insulation layer (e.g., the (2-1)th insulation layer 422 in FIG. 7). The (1-1)th insulation layer may be stacked on the first conductive layer. The (1-1)th insulation layer may be disposed to face in a direction opposite to the (1-1)th coverlay layer. The (2-1)th insulation layer may be stacked on the second conductive layer. The (2-1)th insulation layer may be disposed to face in a direction opposite to the second coverlay layer. The (2-1)th insulation layer may be configured to form the same insulation layer as the (1-1)th insulation layer.

According to an embodiment, the thickness of the first conductive layer may be substantially the same as the thickness of the (1-1)th insulation layer. The thickness of the second conductive layer may be substantially the same as the thickness of the (2-1)th insulation layer.

According to an embodiment, the flexible circuit board may further include a first film layer (e.g., the first film layer 419 in FIG. 7) or a second film layer (e.g., the second film layer 429 in FIG. 7). The first film layer may be stacked on the (1-2)th coverlay layer. The first film layer may be disposed to face in a direction opposite to the (1-1)th coverlay layer. The second film layer may be stacked on the second coverlay layer. The second film layer may be disposed to face in a direction opposite to the second conductive layer.

According to an embodiment, the thickness of the first film layer may be substantially the same as the thickness of the second film layer.

According to an embodiment, the first film layer and the second film layer may be formed as separate film layers.

According to an embodiment, the first film layer and the second film layer may be formed as an integral film layer.

According to an embodiment, the (1-1)th coverlay layer may include a (1-1)th adhesive layer (e.g., the (1-1)th adhesive layer 415 in FIG. 7) or a (1-2)th insulation layer (e.g., the (1-2)th insulation layer 416 in FIG. 7). The (1-1)th adhesive layer may be stacked on the first conductive layer. The (1-2)th insulation layer may be stacked on the (1-1)th adhesive layer. The (1-2)th insulation layer may be disposed to face in a direction opposite to the first conductive layer.

According to an embodiment, the second coverlay layer may include a second adhesive layer (e.g., the second adhesive layer 425 in FIG. 7), or a (2-2)th insulation layer (e.g., the (2-2)th insulation layer 426 in FIG. 7). The second adhesive layer may be stacked on the second conductive layer. The second adhesive layer may be configured to form the same adhesive layer as the (1-1)th adhesive layer. The (2-2)th insulation layer may be stacked on the second adhesive layer. The (2-2)th insulation layer may be disposed to face in a direction opposite to the second conductive layer. The (2-2)th insulation layer may be configured to form the same insulation layer as the (1-2)th insulation layer.

According to an embodiment, the thickness of the (1-1)th adhesive layer may be greater than the thickness of the (1-2)th insulation layer.

According to an embodiment, the (1-2)th coverlay layer may include a (1-2)th adhesive layer (e.g., the (1-2)th adhesive layer 417 in FIG. 7) or a (1-3)th insulation layer (e.g., the (1-3)th insulation layer 418 in FIG. 7). The (1-2)th adhesive layer may be stacked on the (1-2)th insulation layer. The (1-2)th adhesive layer may be disposed to face in a direction opposite to the (1-1)th adhesive layer. The (1-3)th insulation layer may be stacked on the (1-2)th adhesive layer. The (1-3)th insulation layer may be disposed to face in a direction opposite to the (1-2)th insulation layer.

According to an embodiment, the thickness of the (1-2)th adhesive layer may be greater than the thickness of the (1-3)th insulation layer.

According to an embodiment, the thickness of the (1-1)th adhesive layer may be greater than the thickness of the (1-2)th adhesive layer.

According to an embodiment, the thickness of the (1-2)th insulation layer may be greater than the thickness of the (1-3)th insulation layer.

According to an embodiment of the disclosure, a flexible circuit board (e.g., the flexible circuit board 300 in FIG. 5 an FIG. 6B, or the flexible circuit board 400 in FIG. 7) may include a first area (e.g., the first area 401 in FIG. 7), or a second area (e.g., the second area 402 in FIG. 7). The first area may be at least partially configured to be bendable. The first area may include a first conductive layer (e.g., the first conductive layer 413 in FIG. 7), a (1-1)th coverlay layer (e.g., the (1-1)th coverlay layer 415 and 416 in FIG. 7), or a (1-2)th coverlay layer (e.g., the (1-2)th coverlay layer 417 and 418 in FIG. 7). The (1-1)th coverlay layer may be stacked on the first conductive layer. The (1-2)th coverlay layer may be stacked on the (1-1)th coverlay layer. The second area may be configured to extend from the first area. The second area may include a second conductive layer (e.g., the second conductive layer 423 in FIG. 7) or a second coverlay layer (e.g., the second coverlay layer 425 and 426 in FIG. 7). The second conductive layer may be configured to form the same conductive layer as the first conductive layer. The second coverlay layer may be configured to form the same coverlay layer as the (1-1)th coverlay layer.

According to an embodiment, the flexible circuit board may further include a first film layer (e.g., the first film layer 419 in FIG. 7) or a second film layer (e.g., the second film layer 429 in FIG. 7). The first film layer may be stacked on the (1-2)th coverlay layer. The second film layer may be stacked on the second coverlay layer.

According to an embodiment, the (1-1)th coverlay layer may include a (1-1)th adhesive layer (e.g., the (1-1)th adhesive layer 415 in FIG. 7) or a (1-2)th insulation layer (e.g., the (1-2)th insulation layer 416 in FIG. 7). The (1-1)th adhesive layer may be stacked on the first conductive layer. The (1-2)th insulation layer may be stacked on the (1-1)th adhesive layer. The (1-2)th insulation layer may be disposed to face in a direction opposite to the first conductive layer. The second coverlay layer may include a second adhesive layer (e.g., the second adhesive layer 425 in FIG. 7), or a (2-2)th insulation layer (e.g., the (2-2)th insulation layer 426 in FIG. 7). The second adhesive layer may be stacked on the second conductive layer. The second adhesive layer may be configured to form the same adhesive layer as the (1-1)th adhesive layer. The (2-2)th insulation layer may be stacked on the second adhesive layer. The (2-2)th insulation layer may be disposed to face in a direction opposite to the second conductive layer. The (2-2)th insulation layer may be configured to form the same insulation layer as the (1-2)th insulation layer.

According to an embodiment, the (1-2)th coverlay layer may include a (1-2)th adhesive layer (e.g., the (1-2)th adhesive layer 417 in FIG. 7) or a (1-3)th insulation layer (e.g., the (1-3)th insulation layer 418 in FIG. 7). The (1-2)th adhesive layer may be stacked on the (1-2)th insulation layer. The (1-2)th adhesive layer may be disposed to face in a direction opposite to the (1-1)th adhesive layer. The (1-3)th insulation layer may be stacked on the (1-2)th adhesive layer. The (1-3)th insulation layer may be disposed to face in a direction opposite to the (1-2)th insulation layer.

According to an embodiment, the thickness of the first area may be greater than the thickness of second area.

In the above descriptions, although specific embodiments are described in the detailed description of the document, it will be obvious to a person skilled in the art that various changes are possible within the range without departing from the scope of the document.

## Claims

1. An electronic device (101) comprising:
a housing (202) comprising a first housing (210) and a second housing (220);
a hinge structure (280) configured to rotatably connect the first housing (210) and the second housing (220); and
a flexible circuit board (400) at least partially disposed on the hinge structure (280),
wherein the flexible circuit board (400) comprises:
a first area (401) at least partially configured to be bendable, the first area (401) comprising a first conductive layer (413), a (1-1)th coverlay layer (415, 416) stacked on the first conductive layer (413), and a (1-2)th coverlay layer (417, 418) stacked on the (1-1)th coverlay layer (415, 416); and
a second area (402) configured to extend from the first area (401), the second area (402) comprising a second conductive layer (423) configured to form the same conductive layer as the first conductive layer (413), and a second coverlay layer (425, 426) configured to form the same coverlay layer as the (1-1)th coverlay layer (415, 416).

2. The electronic device of claim 1, wherein the thickness of the first area (401) is greater than the thickness of the second area (402).

3. The electronic device of any one of claims 1 and 2, wherein the flexible circuit board (400) further comprises:
a (1-1)th insulation layer (412) stacked on the first conductive layer (413) and disposed to face in a direction opposite to the (1-1)th coverlay layer (415, 416); and
a (2-1)th insulation layer (422) stacked on the second conductive layer (423), disposed to face in a direction opposite to the second coverlay layer (425, 426), and configured to form the same insulation layer as the (1-1)th insulation layer (412).

4. The electronic device of any one of claims 1 to 3, wherein the thickness of the first conductive layer (413) is substantially identical to the thickness of the (1-1)th insulation layer (412), and
the thickness of the second conductive layer (423) is substantially identical to the thickness of the (2-1)th insulation layer (422).

5. The electronic device of any one of claims 1 to 4, wherein the flexible circuit board (400) further comprises:
a first film layer (419) stacked on the (1-2)th coverlay layer (417, 418) and disposed to face in a direction opposite to the (1-1)th coverlay layer (415, 416); and
a second film layer (429) stacked on the second coverlay layer (425, 426) and disposed to face in a direction opposite to the second conductive layer (423),
wherein the thickness of the first film layer (419) is substantially identical to the thickness of the second film layer (429).

6. The electronic device of any one of claims 1 to 5, wherein the (1-1)th coverlay layer (415, 416) comprises:
a (1-1)th adhesive layer (415) stacked on the first conductive layer (413); and
a (1-2)th insulation layer (416) stacked on the (1-1)th adhesive layer (415) and disposed to face in a direction opposite to the first conductive layer (413).

7. The electronic device of any one of claims 1 to 6, wherein the second coverlay layer (425, 426) comprises:
a second adhesive layer (425) stacked on the second conductive layer (423) and configured to form the same adhesive layer as the (1-1)th adhesive layer (415); and
a (2-2)th insulation layer (426) stacked on the second adhesive layer (425), disposed to face in a direction opposite to the second conductive layer (423), and configured to form the same insulation layer as the (1-2)th insulation layer (416).

8. The electronic device of any one of claims 1 to 7, wherein the thickness of the (1-1)th adhesive layer (415) is greater than the thickness of the (1-2)th insulation layer (416).

9. The electronic device of any one of claims 1 to 8, wherein the (1-2)th coverlay layer (417, 418) comprises:
a (1-2)th adhesive layer (417) stacked on the (1-2)th insulation layer (416) and disposed to face in a direction opposite to the (1-1)th adhesive layer (415); and
a (1-3)th insulation layer (418) stacked on the (1-2)th adhesive layer (417) and disposed to face in a direction opposite to the (1-2)th insulation layer (416),
wherein the thickness of the (1-2)th adhesive layer (417) is greater than the thickness of the (1-3)th insulation layer (418).

10. The electronic device of any one of claims 1 to 9, wherein the thickness of the (1-1)th adhesive layer (415) is greater than the thickness of the (1-2)th adhesive layer (417).

11. The electronic device of any one of claims 1 to 10, wherein the thickness of the (1-2)th insulation layer (416) is greater than the thickness of the (1-3)th insulation layer (418).

12. A flexible circuit board (400) comprising:
a first area (401) at least partially configured to be bendable, the first area comprising a first conductive layer (413), a (1-1)th coverlay layer (415, 416) stacked on the first conductive layer, and a (1-2)th coverlay layer (417, 418) stacked on the (1-1)th coverlay layer (415, 416); and
a second area (402) configured to extend from the first area, the second area comprising a second conductive layer (423) configured to form the same conductive layer as the first conductive layer (413), and a second coverlay layer (425, 426) configured to form the same coverlay layer as the (1-1)th coverlay layer (415, 416).

13. The flexible circuit board of claim 12, wherein the first area (401) further comprises a first film layer (419) stacked on the (1-2)th coverlay layer (417, 418), and
the second area (402) further comprises a second film layer (429) stacked on the second coverlay layer (425, 426).

14. The flexible circuit board of any one of claims 12 and 13, wherein the (1-1)th coverlay layer (415, 416) comprises:
a (1-1)th adhesive layer (415) which is stacked on the first conductive layer (413); and
a (1-2)th insulation layer (416) which stacked on the (1-1)th adhesive layer (415) and faces in a direction opposite to the first conductive layer (413), and
the second coverlay layer (425, 426) comprises:
a second adhesive layer (425) which is stacked on the second conductive layer (423) and forming the same adhesive layer as the (1-1)th adhesive layer (415); and
a (2-2)th insulation layer (426) which is stacked on the second adhesive layer (425), faces to be oriented in a direction opposite to the second conductive layer (423), and is configured to form the same insulation layer as the (1-2)th insulation layer (416).

15. **16.** The flexible circuit board of any one of claims 12 to 14, wherein the (1-2)th coverlay layer (417, 418) comprises:
a (1-2)th adhesive layer (417) which is stacked on the (1-2)th insulation layer (416) and faces in a direction opposite to the (1-1)th adhesive layer (415); and
a (1-3)th insulation layer (418) which is tacked on the (1-2)th adhesive layer (417) and faces in a direction opposite to the (1-2)th insulation layer (416).
